(19) Europäisches Patentamt
European Patent Office
Office européen des brevets

(11) **EP 3 655 412 B1**

(12) **FASCICULE DE BREVET EUROPEEN**

(45) Date de publication et mention de la délivrance du brevet:
**09.08.2023 Bulletin 2023/32**

(21) Numéro de dépôt: **18762355.8**

(22) Date de dépôt: **19.07.2018**

(51) Classification Internationale des Brevets (IPC):
**C07F 7/24** [(2006.01)] **H10K 30/15** [(2023.01)]

(52) Classification Coopérative des Brevets (CPC):
**C07F 7/24; H10K 30/151;** H01L 2031/0344;
Y02E 10/549

(86) Numéro de dépôt international:
**PCT/FR2018/051840**

(87) Numéro de publication internationale:
**WO 2019/016476 (24.01.2019 Gazette 2019/04)**

(54) **PÉROVSKITES HYBRIDES ORGANIQUE-INORGANIQUE**

ORGANISCH-ANORGANISCHE HYBRID-PEROWSKITE

ORGANIC-INORGANIC HYBRID PEROVSKITES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.07.2017 FR 1756883**

(43) Date de publication de la demande:
**27.05.2020 Bulletin 2020/22**

(73) Titulaires:
- **Université d'Angers**
  **49100 Angers (FR)**
- **Centre National de la Recherche Scientifique**
  **75016 Paris (FR)**
- **Chimie ParisTech**
  **75005 Paris (FR)**

(72) Inventeurs:
- **MERCIER, Nicolas**
  **49460 Feneu (FR)**
- **LEBLANC, Antonin**
  **53470 Châlons-du-Maine (FR)**
- **PAUPORTÉ, Thierry**
  **94300 Vincennes (FR)**

(74) Mandataire: **Novagraaf Technologies**
**Bâtiment O2**
**2, rue Sarah Bernhardt**
**CS90017**
**92665 Asnières-sur-Seine Cedex (FR)**

(56) Documents cités:
- XIAOPENG ZHENG ET AL: "Defect passivation in hybrid perovskite solar cells using quaternary ammonium halide anions and cations", NATURE ENERGY, vol. 2, no. 7, 26 juin 2017 (2017-06-26), pages 17102-1, XP55515514, GB ISSN: 2058-7546, DOI: 10.1038/nenergy.2017.102
- DUYEN H. CAO ET AL: "2D Homologous Perovskites as Light-Absorbing Materials for Solar Cell Applications", JOURNAL OF THE AMERICAN CHEMICAL SOCIETY, vol. 137, no. 24, 28 mai 2015 (2015-05-28), pages 7843-7850, XP055377376, US ISSN: 0002-7863, DOI: 10.1021/jacs.5b03796
- C.I.COVALIU ET AL: "Electrical properties of new organo-inorganic layered perovskites", OPTOELECTRONICS AND ADVANCED MATERIALS - RAPID COMMUNICATIONS, vol. 5, no. 10, 2011, pages 1097-1102, XP002785713,
- JIANFENG LU ET AL: "Diammonim and monoammonium mixed-organice-cation Perovskites for high performance solar cells improved stability", ADVANCED ENERGY MATERIALS, vol. 7, 1700444, 23 mai 2017 (2017-05-23), XP002778824, ISSN: 1614-6832

**Description**

La présente invention concerne des pérovskites hybrides organique-inorganique, et leurs utilisations pour la préparation de cellules solaires.

La pérovskite désigne à l'origine le minéral $CaTiO_3$ (titanate de calcium). De nombreux oxydes de formule $ABO_3$ adoptent une structure de type pérovskite. Des pérovskites hybride organique-inorganique $ABX_3$ ont été développées pour des applications en photovoltaïque. MAPI, de formule $(CH_3NH_3)PbI_3$, est une pérovskite hybride organique-inorganique tridimensionnelle (3D) qui a révolutionné le domaine du photovoltaïque en raison du rendement de conversion élevé des cellules photovoltaïques à pérovskites (PSCs) (>20%) et du coût faible de fabrication de ces cellules. Néanmoins, ce matériau présente deux inconvénients majeurs : la présence de plomb, qui est un élément toxique, et l'instabilité de cette pérovskite hybride à l'humidité.

Des pérovskites alternatives ont été préparées afin de limiter la présence de plomb :

- en substituant le plomb ($Pb^{2+}$) par l'étain ($Sn^{2+}$) conduisant à une pérovskite $(CH_3NH_3)(Pb)_{1-x}(Sn)_xI_3$, mais les rendements de conversion photovoltaïque sont faibles.
- en substituant le plomb ($Pb^{2+}$) par $Ag^+$ et $Bi^{3+}$ ($2Pb^{2+} \Leftrightarrow Ag^+ + Bi^{3+}$), mais les rendements sont également faibles.

Afin d'améliorer la stabilité à l'humidité, la stratégie la plus efficace concerne la conception même de la cellule. En effet, la fabrication de cellules de type inverse protège la couche MAPI de l'humidité, plus que dans la configuration de type directe. Une autre stratégie consiste à utiliser des pérovskites hybrides bidimensionnelles (2D) (par exemple $(C_6H_5-EtNH_3)_2(MeNH_3)_2[Pb_3I_{10}]$, $(BA)_2(MeNH_3)_2[Pb_3I_{10}]$ ou $(BA)_2(MeNH_3)_3[Pb_4I_{13}]$, où BA représente le butylammonium) qui, lorsque l'orientation du film mince est adaptée, présentent des rendements photovoltaïques convenables (12%) et une stabilité améliorée.

Diverses autres substitutions sur MAPI ont été rapportées dans la littérature :

- en substituant le cation $CH_3NH_3^+$ ($A^+$) par un autre cation $A'^+$ conduisant à une solution solide $(A)_{1-x}(A')_xPbI_3$,
- en substituant l'anion conduisant à des pérovskites de formule $(CH_3NH_3)Pb(I)_{3-x}(X')_X$ dans laquelle X' représente Cl ou Br,
- en substituant à la fois le cation et l'anion.

Le document Zheng et al. (Nature Energy, vol. 2 (7), 2017, 17102-1, DOI : 10.1038/nenergy.2017.102) est relatif à l'effet de sels d'ammonium quaternaire sur la passivation de défauts ioniques à la surface des domaines cristallisés de pérovskites hybrides, entrainant des rendements de photoconversion améliorés. Les pérovskites hybrides étudiées dans ce document sont de type $(A^1,A^2)Pb(X^1, X^2)_3$. Ces pérovskites se différentient du composé de référence MAPI, $(CH_3NH_3)PbI_3$ par la substitution partielle du cation $CH_3NH_3^+$ par le cation monovalent formamidinium, et celle de l'anion iodure $I^-$ par l'anion bromure $Br^-$.

Le document Duyen et al. (J. Am. Chem. Soc. 2015, 137, 24, 7843-7850, https://doi.org/10.1021/jacs.5b03796) est relatif à la fabrication et aux propriétés des couches minces de pérovskite 2D semi-conductrice $(CH_3(CH_2)_3NH_3)_2(CH_3NH_3)_{n-1}PbnI_{3n+1}$ dans laquelle n = 1, 2, 3 ou 4.

Covaliu et al. in Optoelectronics and Advanced Materials 2011, vol 5, no. 10, 1097-1102 divulgue des pérovskites avec choline comme fraction cationique et avec des métaux mixtes. J. Lu dans Advanced Energy Materials 2017, 7, 1700444 divulgue des pérovskites à cations organiques mixtes diammonium et monoammonium pour cellules photovoltaïques avec une stabilité améliorée.

Le développement de pérovskites alternatives comprenant moins de plomb et/ou étant plus stable à l'humidité que MAPI, tout en conservant des rendements de conversion élevés, est donc requis.

A cet effet, selon un premier objet, l'invention concerne une pérovskite hybride organique-inorganique ayant une structure tridimensionnelle de formule (I) suivante :

$$[(A)_{1-2\cdot48p-b}(B)_{3,48p+b}]_{(1+2p-y)/(1+p)}(Pb)_{1-p-m}(M)_m(X^1)_{3-y-q}(X^2)_q \qquad (I)$$

dans laquelle :

- A représente un cation choisi parmi Cs, Rb et un cation organique monovalent comprenant un groupe ammonium ou carboxamidamidium,
- B représente un cation organique monovalent de formule (II) suivante :

$$R^1-(CH_2)_z-R^2 \qquad (II)$$

dans laquelle :

- $R^2$ représente un groupe ammonium ou carboxamidamidium,
- z représente 1, 2 ou 3, et
- $R^1$ représente -H, -OH, -SH, -CN ou un halogène,

sous réserve que B soit différent de A,
- $X^1$ et $X^2$ représentent un halogénure, sous réserve que $X^1$ et $X^2$ soient différents l'un de l'autre,
- p est un nombre supérieur à 0 et inférieur ou égal à 0,30,
- b est un nombre supérieur ou égal à -0,30 et inférieur ou égal à 0,30, sous réserve que b soit supérieur à -3,48p et soit inférieur à (1 - 2,48p),
- y représente un nombre supérieur à 0 et inférieur ou égal à p,
- q représente un nombre supérieur ou égal à 0 et inférieur ou égal à (3-y),
- M représente un cation métallique divalent, et
- m représente un nombre supérieur ou égal à 0 et inférieur ou égal à (1-p).

Dans la présente demande, par « supérieur à un nombre X » ou « inférieur ou nombre X », on entend que le nombre X est exclu.

L'invention consiste à substituer des ions $Pb^{2+}$, $I^-$ et $MA^+$ de la pérovskite MAPI par des cations organiques $B^+$. La pérovskite selon l'invention est nécessairement déficiente en plomb car p est différent de 0. La pérovskite selon l'invention comprend nécessairement l'entité B, car b est supérieur à -3,48p. En conséquence la quantité de plomb par unité de volume est moindre dans les pérovskites selon l'invention par rapport au MAPI, tout en conservant la structure tridimensionnelle du MAPI. D'autre part, la stabilité à l'humidité semble au moins comparable, voire même améliorée, par rapport à la stabilité à l'humidité observée pour MAPI.

De manière générale, un réseau pérovskite est un réseau d'octaèdres $MX_6$ liés par sommets. Dans les pérovskites hybrides dites « 2D » cette connexion par sommet s'étend dans 2 directions de l'espace (2 dimensions). Dans les pérovskites selon l'invention, comme dans le composé $(CH_3NH_3)PbI_3$, les octaèdres sont connectés par sommet selon les 3 directions de l'espace (3 dimensions).

A titre illustratif, la figure annexée est un schéma du réseau inorganique (atomes Pb, I représentés) et d'atomes d'azote d'une pérovskite hybride organique-inorganique selon l'invention de formule (X) suivante (qui correspond à la formule (I) dans laquelle p = y = 0,2 ; m = q = b = 0 ; A = MA = $MeNH_3^+$ ; B représente $HO-(CH_2)_2-NH_3^+$) :

$$(MA)_{0,504} (HO-(CH_2)_2-NH_3^+)_{0,696}Pb_{0,8}I_{2,8} \qquad (X)$$

Le réseau de cette pérovskite est déficient en entités $(PbI)^+$ par rapport au réseau d'une pérovskite $(MA)_{15}Pb_5I_{15}$ (qui correspond à MAPI). Cette déficience est notamment visible aux positions situées au centre et aux quatre coins de la figure, où des cavités sont visibles (contenant des N à la place de Pb et I). Pour 0 < p < 0,2, la pérovskite est plus riche en Pb et en I que celle de formule (X), et des Pb et I se localisent dans les cavités. Pour 0,2 < p < 0,30, la pérovskite est moins riche en Pb que celle de formule (X), et il y a plus de cavités dans le réseau que celles illustrées sur la figure.

Dans la formule (I), le facteur $\frac{1+2p-y}{1+p}$ permet d'assurer l'électroneutralité des pérovskites selon l'invention. En effet, la charge négative portée par la partie inorganique $Pb(+II)/M(+II)/X^1(-I)/X^2(-I)$ est : (3-y-q) + q - 2(1-p-m) - 2m = 1 + 2p -y (quand y = p : la charge négative est 1 + p). Il faut donc 1+ 2p - y charges positives apportées par les cations A et B. Entre crochet, il y a (1 + p) cations A + B. Le facteur $\frac{1+2p-y}{1+p}$ équilibre donc la charge. Quand y = p, il y a (1+p) charges négatives et (1 + p) cations A+B. Quand y est inférieur à p, la charge négative augmente, il faut donc plus de cations pour compenser, à savoir 1 + 2p -y.

Les inventeurs ont observé que, dans les pérovskites selon l'invention, il y a une corrélation entre p et le nombre de cation A d'une part et le nombre de cation B d'autre part. Plus précisément :

- la quantité de cation B est proche d'une fonction linéaire de p, à savoir 3,48p, et est dans le domaine de (3,48p + b), et
- la quantité de cation A est également proche d'une fonction linéaire de p, à savoir (1 - 2,48p), et est dans le domaine de (1 - 2,48p - b).

L'indice b définit un domaine de part et d'autre de ces fonctions linéaires.

$X^1$ représente de préférence un iodure. La pérovskite a alors la formule (IIa) suivante :

$$[(A)_{1-2,48p-b}(B)_{3,48p+b}]_{(1+2p-y)/(1+p)}(Pb)_{1-p-m}(M)_m(I)_{3-y-q}(X^2)_q \qquad (IIa),$$

dans laquelle A, B, p, M, m, b, y et q sont tels que définis ci-dessus et $X^2$ représente un halogénure choisi parmi Br, Cl et F, de préférence Br et Cl.

La pérovskite peut être exempte d'halogénure autre que l'iodure : $X^1$ représente alors un iodure et q représente 0. La pérovskite a alors la formule (III) suivante :

$$[(A)_{1-2,48p-b}(B)_{3,48p+b}]_{(1+2p-y)/(1+p)}(Pb)_{1-p-m}(M)_m(I)_{3-y} \qquad (III),$$

dans laquelle A, B, p, M, b, y et m sont tels que définis ci-dessus.

La pérovskite peut être exempte de métal M autre que le plomb : m représente alors 0. La pérovskite a alors la formule (IV) suivante :

$$[(A)_{1-2,48p-b}(B)_{3,48p+b}]_{(1+2p-y)/(1+p)}(Pb)_{1-p}(X^1)_{3-y-q}(X^2)_q \qquad (IV),$$

dans laquelle A, B, p, $X^1$, $X^2$, b, y et q sont tels que définis ci-dessus.

Dans la formule (IV), $X^1$ représente de préférence un iodure et la pérovskite a alors la formule (V) suivante :

$$[(A)_{1-2,48p-b}(B)_{3,48p+b}]_{(1+2p-y)/(1+p)}(Pb)_{1-p}(I)_{3-y-q}(X^2)_q \qquad (V),$$

dans laquelle A, B, p, b, y et q sont tels que définis ci-dessus et $X^2$ représente un halogénure choisi parmi Br, Cl et F, de préférence Br et Cl. Cette pérovskite peut être exempte d'halogénure autre que l'iodure et avoir la formule (VI) suivante :

$$[(A)_{1-2,48p-b}(B)_{3,48p+b}]_{(1+2p-y)/(1+p)}(Pb)_{1-p}(I)_{3-y} \qquad (VI),$$

dans laquelle A, B, b, y et p sont tels que définis ci-dessus.

Les modes de réalisations suivants, considérés indépendamment ou combinés les uns avec les autres, sont applicables aux formules ci-dessus :
De préférence, y est égal à p.

De préférence, p est un nombre supérieur à 0 et inférieur ou égal à 0,25, notamment de 0,01 à 0,25, en particulier de 0,05 à 0,23.

De préférence, b est un nombre supérieur ou égal à -0,20 et inférieur ou égal à 0,20, notamment un nombre supérieur ou égal à -0,10 et inférieur ou égal à 0,10, en particulier un nombre supérieur ou égal à -0,07 et inférieur ou égal à 0,07.

De préférence, m représente 0 et/ou q représente 0.

Parmi les cations métalliques divalents M peuvent être cités Pb, Sn, Cu, Cd et Mn.

Parmi les halogénures $X^1$ et $X^2$ peuvent être cités un iodure, un chlorure, un bromure, ou un fluorure, de préférence un iodure, un chlorure ou un bromure.

Parmi les halogènes des groupes $R^1$ peuvent être cités un iode, un chlore, un brome, ou un fluor, de préférence un chlore, un brome, ou un fluor, le fluor étant particulièrement préféré.

Le groupe $-NH_3^+$ est le groupe ammonium préféré.

Le cation A peut être choisi parmi Cs et Rb.

Le cation A peut être un cation organique monovalent comprenant un groupe ammonium ou carboxamidamidium. Le cation A comprend typiquement (voire est constitué de) :

- le groupe ammonium ou carboxamidamidium et
- une hydrogène -H ou un hydrocarbure comprenant de 1 à 4 atomes de carbone, notamment un ou deux atomes de carbone, de préférence un alkyle comme le méthyle ou l'éthyle.

Parmi les cations organiques monovalents comprenant un groupe ammonium possibles pour le cation A, on peut citer le méthylammonium (MA) de formule $CH_3NH_3^+$. Le groupe $-C(NH_2)_2^+$ est le carboxamidamidium préféré. Le formamidinium de formule $HC(NH_2)_2^+$ (FA) est le cation organique monovalent comprenant un groupe carboxamidamidium le plus usuel. De préférence, A représente le méthylammonium (MA) ou le formamidinium (FA).
Le cation A est différent du cation B.

De préférence, dans la formule (II) :

- $R^2$ représente un groupe $-NH_3^+$, et/ou
- z représente 1 ou 2, de préférence 2, et/ou

- $R^1$ représente -H, -OH, -SH, -CN ou un halogène, notamment -OH, -SH, -CN ou un halogène, en particulier -OH ou -SH, de préférence -OH.

Lorsque $R^1$ représente -H, le cation organique monovalent B de formule (II) peut être $CH_3CH_2NH_3^+$ ou $CH_3C(NH_2)_2^{2+}$.

Lorsque $R^1$ représente -OH, le cation organique monovalent B de formule (II) préféré est $HO-(CH_2)_2-NH_3^+$.

Lorsque $R^1$ représente -SH, le cation organique monovalent B de formule (II) préféré est $HS-(CH_2)_2-NH_3^+$.

De manière particulièrement préférée, la pérovskite a la formule (VII) suivante :

$$[(A)_{1-2,48p-b}(HO-(CH_2)_2-NH_3^+)_{3,48p+b}]_{(1+2p-y)/(1+p)}(Pb)_{1-p}(I)_{3-y} \qquad (VII)$$

dans laquelle A, p, b et y sont tels que définis ci-dessus, de préférence A représente MA et/ou y = p.

Les pérovskites de formules (90), (92), (89), (93) et (88) suivantes sont particulièrement préférées :

$$(CH_3NH_3)_{0,8138}(HO-(CH_2)_2-NH_3)_{0,2848}[Pb_{0,9014}I_{2,9014}] \qquad (90),$$

(dans la formule (I), A = $CH_3NH_3$ ; B = $HO-(CH_2)_2-NH_3$ ; m = q = 0 ; y = p = 0,0986 ; b = -0,058328)

$$(CH_3NH_3)_{0,6744}(HO-(CH_2)_2-NH_3)_{0,4586}[Pb_{0,8670}I_{2,8670}] \qquad (92),$$

(dans la formule (I), A = $CH_3NH_3$ ; B = $HO-(CH_2)_2-NH_3$ ; m = q = 0 ; y = p = 0,133 ; b = - 0,00424)

$$(CH_3NH_3)_{0,5821}(HO-(CH_2)_2-NH_3)_{0,5763}[Pb_{0,8416}I_{2,8416}] \qquad (89),$$

(dans la formule (I), A = $CH_3NH_3$ ; B = $HO-(CH_2)_2-NH_3$ ; m = q = 0 ; y = p = 0,1584 ; b = 0,025068)

$$(CH_3NH_3)_{0,5383}(HO-(CH_2)_2-NH_3)_{0,6405}[Pb_{0,8212}I_{2,8212}] \qquad (93),$$

(dans la formule (I), A = $CH_3NH_3$ ; B = $HO-(CH_2)_2-NH_3$ ; m = q = 0 ; y = p = 0,1788 ; b = 0,018276) ou

$$(CH_3NH_3)_{0,4730}(HO-(CH_2)_2-NH_3)_{0,7331}[Pb_{0,7940}I_{2,7940}] \qquad (88)$$

(dans la formule (I), A = $CH_3NH_3$ ; B = $HO-(CH_2)_2-NH_3$ ; m = q = 0 ; y = p = 0,206 ; b = 0,01622).

De manière particulièrement préférée, la pérovskite a la formule (VIII) suivante :

$$[(A)_{1-2,48p-b}(HS-(CH_2)_2-NH_3^+)_{3,48p+b}]_{(1+2p-y)/(1+p)}(Pb)_{1-p}(I)_{3-y} \qquad (VIII)$$

dans laquelle A, p, b et y sont tels que définis ci-dessus, de préférence A représente FA et/ou y = p.

La pérovskite de formule (T1) suivante est particulièrement préférée :

$$(HC-(NH_2)_2)_{0,9177}(HS-(CH_2)_2-NH_3)_{0,1193}[Pb_{0,9630}I_{2,9630}] \qquad (T1),$$

(dans la formule (I), A = $HC-(NH_2)_2$ ; B = $HS-(CH_2)_2-NH_3$ ; m = q = 0 ; y = p = 0,037 ; b = -0,00946).

Dans la présente demande et comme souvent dans les structures des pérovskites, les charges positives des cations ou anions ne sont pas toujours représentées. Il est sous-entendu que Pb correspond à $Pb^{2+}$, Sn à $Sn^{2+}$, Cu à $Cu^{2+}$, Cd à $Cd^{2+}$, Mn à $Mn^{2+}$, Cs à $Cs^+$ et Rb à $Rb^+$, $CH_3NH_3$ à $CH_3NH_3^+$, $HO-(CH_2)_2-NH_3$ à $HO-(CH_2)_2-NH_3^+$, $HC-(NH_2)_2$ à $HC-(NH_2)_2^+$, $HS-(CH_2)_2-NH_3$ à $HS-(CH_2)_2-NH_3^+$.

Les pérovskites selon l'invention peuvent se présenter sous différentes formes, notamment sous forme de poudre cristallisée ou de cristaux. Elles ont une structure tridimensionnelle, comme MAPI. Généralement, les pérovskites selon l'invention ont un système cristallin de symétrie tétragonale, comme MAPI.

Les pérovskites peuvent également se présenter sous forme de couche mince recouvrant au moins une partie de la surface d'un substrat. Cette surface est par exemple la surface d'un matériau transporteur d'électrons. Par exemple, le substrat est du verre recouvert d'une couche de couche d'oxyde d'étain dopée au fluor (« fluorine doped tin oxide » (FTO) en anglais) ou d'une couche d'oxyde d'indium et d'étain (« Indium Tin oxide » (ITO) en anglais) sur lequel au moins une couche de matériau transporteur d'électrons (« electron transport layer » (ETL) en anglais), comme du $TiO_2$, du $SnO_2$, du ZnO a été déposée.

Selon un deuxième objet, l'invention concerne un procédé de préparation des pérovskites définies ci-dessus.

Elles peuvent être préparées en appliquant les procédés de préparation du MAPI par analogie, sauf à introduire un sel dont le cation est B tel que défini ci-dessus. Typiquement, pour obtenir des pérovskites sous forme de cristaux/poudre cristallisée, les méthodes suivantes peuvent être utilisées :

- l'évaporation d'une solution sursaturée comprenant :

  - un sel dont le cation est A tel que défini ci-dessus,
  - un sel dont le cation est B tel que défini ci-dessus,
  - un halogénure de plomb, et
  - éventuellement un halogénure de cation métallique divalent M,

- l'ajout d'un non-solvant à une telle solution sursaturée, ou
- une méthode solvothermale.

L'adaptation des proportions molaires [sel dont le cation est A tel que défini ci-dessus / sel dont le cation est B tel que défini ci-dessus / halogénure de plomb / éventuellement un halogénure de cation métallique divalent M] permet d'obtenir des pérovskites avec des valeurs de p, q et m différentes.

Pour obtenir des pérovskites sous forme de couche mince sur la surface d'un substrat, différentes méthodes peuvent être utilisées :

- un dépôt par enduction centrifuge (« spin-coating » en anglais) sur la surface d'un substrat,
- un dépôt par diffusion de solvant sur la surface d'un substrat puis recuit (« annealing » en anglais), ou
- un dépôt par mise sous pression à l'état solide.

Avantageusement, les pérovskites hybride organique-inorganique selon l'invention présentent des rendements photovoltaïques comparables à celui du MAPI. Elles sont donc particulièrement adaptées à être utilisées dans des cellules solaires.

Selon un troisième objet, l'invention concerne une cellule photovoltaïque à pérovskites (« perovskite solar cells » PSCs en anglais) dont au moins l'une des couches contient la pérovskite définie ci-dessus.

L'architecture de la cellule photovoltaïque peut être planaire de type n-i-p ou p-in, mésoporeuse ou bi-couches (typiquement une couche comprenant la pérovskite selon l'invention et une couche de silicium).

Les exemples qui suivent et la figure annexée illustrent l'invention.

La figure représente un schéma du réseau inorganique (atomes Pb, I et N représentés) d'une pérovskite hybride organique-inorganique de formule (X) suivante :

$$(MA)_{0,452}(B)_{0,748}Pb_{0,8}I_{2,8} \qquad (X)$$

Les pérovskites de formules suivantes ont été préparées dans les exemples :

$$(CH_3NH_3)_{0,8138}(HO\text{-}(CH_2)_2\text{-}NH_3)_{0,2848}[Pb_{0,9014}I_{2,9014}] \qquad (90)$$

$$(CH_3NH_3)_{0,6744}(HO\text{-}(CH_2)_2\text{-}NH_3)_{0,4586}[Pb_{0,8670}I_{2,8670}] \qquad (92)$$

$$(CH_3NH_3)_{0,5821}(HO\text{-}(CH_2)_2\text{-}NH_3)_{0,5763}[Pb_{0,8416}I_{2,8416}] \qquad (89)$$

$$(CH_3NH_3)_{0,5383}(HO\text{-}(CH_2)_2\text{-}NH_3)_{0,6405}[Pb_{0,8212}I_{2,8212}] \qquad (93)$$

$$(CH_3NH_3)_{0,4730}(HO\text{-}(CH_2)_2\text{-}NH_3)_{0,7331}[Pb_{0,7940}I_{2,7940}] \qquad (88)$$

$$(HC\text{-}(NH_2)_2)_{0,9177}(HS\text{-}CH_2CH_2\text{-}NH_3)_{0,1193}[Pb_{0,9630}I_{2,9630}] \qquad (T1).$$

## Exemple 1 : Préparation de pérovskites sous forme de cristaux/poudres cristallisées

Dans un premier temps, une solution précurseur proche de la saturation a été préparée via dissolution d'éthanolamine, d'iodure de méthylammonium, et de $PbI_2$ dans une solution d'acide hydroiodique à 57% (composés Aldrich). Les proportions molaires éthanolamine/iodure de méthylammonium/$PbI_2$ étaient de 1/2/3, 1,5/2/3, 2/2/3, 2,5/2/3, et 3/2/3, pour les pérovskites 90, 92, 89, 93, et 88 respectivement.

Dans un deuxième temps cette solution précurseur a été ajoutée à de l"acétate d'éthyle, conduisant à une précipitation immédiate de la pérovskite. La poudre obtenue a été filtrée, lavée à l'acétate d'éthyle, puis séchée à l'étuve 15 à 20 minutes à 80°C.

La poudre cristallisée obtenue a été analysée en résonance magnétique nucléaire (RMN) et aux rayons X (RX).

* Pérovskite 88 - RMN (DMSO $d_6$). Description :

- 1 signal à 2,39ppm ayant pour intégration 3H, associés au méthyl du ligand méthylammonium
- 1 signal à 2,87ppm ayant pour intégration 3,09H, associés à un -$CH_2$- du ligand éthanolammonium
- 1 signal à 3,58ppm ayant pour intégration 3,15H, associés au deuxième -$CH_2$- du ligand ethanolammonium
- 1 signal large et faible à 5,13ppm ayant pour intégration 1,55H, associé au HO- du ligand éthanolammonium
- 1 signal très large à 7,67ppm ayant pour intégration 7,71ppm, associés aux fonctions ammonium des 2 ligands

* Pérovskite 93 - RMN (DMSO $d_6$). Description :

- 1 signal à 2,39ppm ayant pour intégration 3H, associés au méthyl du ligand méthylammonium
- 1 signal à 2,87ppm ayant pour intégration 2,35H, associés à un -$CH_2$- du ligand éthanolammonium
- 1 signal à 3,58ppm ayant pour intégration 2,41H, associés au deuxième -$CH_2$- du ligand éthanolammonium
- 1 signal large et faible à 5,13ppm ayant pour intégration 1,19H, associé au HO- du ligand éthanolammonium
- 1 signal très large à 7,61ppm ayant pour intégration 6,49ppm, associés aux fonctions ammoniums des 2 ligands

* Pérovskite 89 - RMN (DMSO $d_6$). Description :

- 1 signal à 2,39ppm ayant pour intégration 3H, associés au méthyl du ligand méthylammonium
- 1 signal à 2,87ppm ayant pour intégration 1,98H, associés à un -$CH_2$- du ligand ethanolammonium
- 1 signal à 3,58ppm ayant pour intégration 1,99H, associés au deuxième -$CH_2$- du ligand ethanolammonium
- 1 signal large et faible à 5,14ppm ayant pour intégration 0,99H, associé au HO- du ligand ethanolammonium
- 1 signal très large à 7,60ppm ayant pour intégration 5,90ppm, associés aux fonctions ammoniums des 2 ligands

* Pérovskite 92 - RMN (DMSO $d_6$). Description :

- 1 signal à 2,38ppm ayant pour intégration 3H, associés au méthyl du ligand méthylammonium
- 1 signal à 2,87ppm ayant pour intégration 1,38H, associés à un -$CH_2$- du ligand ethanolammonium
- 1 signal à 3,57ppm ayant pour intégration 1,34H, associés au deuxième -$CH_2$- du ligand ethanolammonium
- 1 signal large et faible à 5,11ppm ayant pour intégration 0,68H, associé au HO- du ligand ethanolammonium
- 1 signal très large à 7,60ppm ayant pour intégration 5,27ppm, associés aux fonctions ammoniums des 2 ligands

* Pérovskite 90 - RMN (DMSO $d_6$). Description :

- 1 signal à 2,39ppm ayant pour intégration 3H, associés au méthyl du ligand méthylammonium
- 1 signal à 2,88ppm ayant pour intégration 0,69H, associés à un -$CH_2$- du ligand ethanolammonium
- 1 signal à 3,58ppm ayant pour intégration 0,71H, associés au deuxième -$CH_2$- du ligand ethanolammonium
- 1 signal large et faible à 5,12ppm ayant pour intégration 0,35H, associé au HO- du ligand ethanolammonium
- 2 signaux larges qui se recouvrent à 7,50ppm et 7,68ppm, et ayant pour intégration totale 4,12ppm, associés aux fonctions ammoniums des 2 ligands

* Etude RX poudre (diffractomètre Bruker D8 advance, anticathode cuivre, détecteur Vantée)

Positions 20 en ° des raies de diffraction des composés dans la gamme angulaire 5-32° Pérovskite 88 : 6,235 ; 8,772 ; 12,412 ; 13,895 ; 18,745 ; 19,690 ; 22,379 ; 24,125 ; 25,669 ; 27,820 ; 28,768 ; 29,418 ; 31,241
Pérovskite 93 : 6,254 ; 8,810 ; 12,421 ; 13,905 ; 17,674; 18,745 ; 19,773 ; 22,494 ; 24,194 ; 24,981 ; 25,746 ; 27,896 ; 28,768 ; 29,380 ; 31,275
Pérovskite 89 : 8,896 ; 12,543 ; 14,012 ; 18,783 ; 19,820 ; 22,571 ; 24,285 ; 25,784 ; 28,011 ; 28,883 ; 29,533 ; 31,412
Pérovskite 92 : 14,092 ; 19,938 ; 24,388 ; 26,014 ; 28,125 ; 31,527
Pérovskite 90 : 13,980 ; 19,820 ; 24,297 ; 25,325 ; 28,125 ; 31,534

Les pérovskites préparées avaient toutes un système cristallin de symétrie tétragonale.
Pour la pérovskite 88, les paramètres de maille sont les suivants :

$$a = b = 14,184\text{Å},$$

$$c = 6,292 \text{ Å}$$

$$\alpha = \beta = \gamma = 90°$$

$$V = 1266 \text{ Å}^3$$

**Exemple 2 : Préparation de pérovskites sous forme de couche minces et d'un dispositif photovoltaïque**

Le dispositif photovoltaïque réalisé se constitue d'un support type verre recouvert d'une couche de couche d'oxyde d'étain dopée au fluor (« fluorine doped tin oxide » (FTO) en anglais) (TEC™(7)), sur lequel une 1ère couche transporteuse d'électrons (« electron transport layer » (ETL) en anglais) de $TiO_2$ compact a été déposée par spray, puis une 2ème couche de $TiO_2$ poreux a été déposée par spin coating. La couche active de pérovskites selon l'invention a été déposée sur le $TiO_2$ poreux via spin coating (solvant Diméthylformamide, solution 1 molaire) suivi d'un recuit à 100°C durant 1 heure, puis la couche de matériau pour le transport des trous (« hole transport material » (HTM) en anglais) type spiro-OMeTAD a été déposée également par spin coating. Pour finir, l'électrode d'argent a été déposée par évaporation.

Dans des conditions non encore optimisées, mais identiques pour toutes les pérovskites testées (à savoir MAPI, pérovskite 90, pérovskite 92 et pérovskite 89), les résultats de rendements photovoltaïques (PCE) sont les suivants (la valeur annoncée est une moyenne sur 5 à 6 mesures) :

| Pérovskite | MAPI (comparatif) | 90 | 92 | 89 |
|---|---|---|---|---|
| PCE (série 1) | 3,35 % | 3,74 % | 2,14 % | 1,88 % |
| PCE (série 2) | 2,97 % | 4,02 % | 2,44 % | 2,07 % |

**Exemple 3 : Préparation de la pérovskite T1 sous forme de poudre cristallisée (pas de cristaux)**

Dans un premier temps, une solution précurseur proche de la saturation a été préparée via dissolution de cysteamine, d'iodure de formamidinium, et de $PbI_2$ dans une solution d'acide hydroiodique à 57% (composés Aldrich). Les proportions molaires cysteamine/iodure de formamidinium/$PbI_2$ étaient de 2,13/3/3.

Dans un deuxième temps cette solution précurseur a été ajoutée à de l"acétate d'éthyle, conduisant à une précipitation immédiate de la pérovskite. La poudre obtenue a été filtrée, lavée à l'acétate d'éthyle, puis séchée à l'étuve 15 à 20 minutes à 60°C.

La poudre cristallisée obtenue a été analysée en résonance magnétique nucléaire (RMN) et aux rayons X (RX).

* Pérovskite T1 - RMN (DMSO $d_6$). Description :

- 1 signal à 2,69 ppm ayant pour intégration 0,14H, associé à l'hydrogène de la fonction HS- du ligand thioéthylammonium.
- 1 signal à 2,96 ppm ayant pour intégration 0,24H, associé à un $-CH_2-$ du ligand thioéthylammonium.
- 1 signal à 3,14 ppm ayant pour intégration 0,24H, associé au deuxième $-CH_2-$ du ligand thioéthylammonium.
- 1 signal à 7,86 ppm ayant pour intégration 1,38H, associé à l'hydrogène HC- du ligand formamidinium avec une contribution d'intégration de 1,00H + associé au $-NH_3^+$ du ligand thioéthylammonium avec une contribution d'intégration de 0,38H.
- 1 signal à 8,66 ppm ayant pour intégration 2,00H, associé à un $-NH_2-$ du ligand formamidinium.
- 1 signal à 9,00 ppm ayant pour intégration 2,00H, associé au deuxième $-NH_2-$ du ligand formamidinium.

* Etude RX poudre (diffractomètre Bruker D8 advance, anticathode cuivre, détecteur ponctuel par scintillation) Positions 20 en ° des raies de diffraction des composés dans la gamme angulaire 5-32° Pérovskite T1 : 13,949 ; 19,749 ; 24,249 ; 28,069 ; 31,449 ; 34,479 ; 40,089 ; 42,629 ; 49,749 ; 51,819 ; 58,139

**Exemple 4 : Préparation de la pérovskite T1 sous forme de couche mince**

La couche mince fut réalisée par spin coating dans des conditions ambiantes. Dans un premier temps la solution contenant les précurseurs a été préparée par dissolution d'iodure de thioéthylammonium / d'iodure de formamidinium / $PbI_2$, dans du dimethylformamide (DMF), et en respectant les proportions steochiométriques suivantes 0,5/3/3. La concentration en $PbI_2$ étant fixée à 1,2 mol/L. Dans un second temps, 60 μL de cette solution sont déposés sur un support 1,5*2 $cm^2$ GLASS/FTO (tec7, Pilkington) côté FTO. Le programme de spin coating imposé ensuite est 10 sec à 1000 rpm (accélération 200 rpm/sec), puis 20 sec à 6000 rpm (accélération 3000 rpm/sec). Durant ce programme (à 15 sec plus précisément), 300 μL d'acétate d'éthyle ou 150 μL de chlorobenzene sont ajouté directement sur le film en rotation. A la fin du spin coating, le film en couche mince subi un traitement thermique sur plaque chauffante à 100°C durant 30 minutes.

Stabilité couche mince

Une comparaison de la stabilité de la pérovskite T1 et de la pérovskite connue $\alpha$-FAPbI$_3$ (FA$^+$= formamidinium, HC(NH2)$_2$$^+$) dans des conditions de laboratoire (air, lumière, 25°C, taux humidité 80% environ) a été menée.

Après préparation des films par spin-coating, ceux-ci ont été laissés sur une paillasse et des analyses par diffraction des rayons X ont été effectuées régulièrement. L'analyse par diffraction des rayons X initiale montre que les films minces préparés correspondent aux phases attendues (positions 20 en ° des raies de diffraction des composés dans la gamme angulaire 5-32° : Pérovskite T1, 13,949, 19,749, 24,249, 28,069, 31,449 ; $\alpha$-FAPbI$_3$, 13,969, 19,767, 24,218, 28,113, 31,510). Après 25h, les premiers signes d'apparition de la phase non pérovskite $\delta$-FAPI apparait pour l'échantillon $\alpha$-FAPbI$_3$ (raie en position 20 11,8°), significatif d'un début de dégradation.

Après 100 h, alors que l'échantillon de $\alpha$-FAPbI$_3$ est complètement transformé en $\delta$-FAPI, aucun signe de dégradation n'a lieu pour l'échantillon T1 (diffractogramme RX identique à l'initial).

**Revendications**

1. - Pérovskite hybride organique-inorganique, ayant une structure tridimensionnelle, de formule (I) suivante :

$$[(A)_{1-2,48p-b}(B)_{3,48p+b}]_{(1+2p-y)/(1+p)}(Pb)_{1-p-m}(M)_m(X^1)_{3-y-q}(X^2)_q \qquad (I)$$

dans laquelle :

- A représente un cation choisi parmi Cs, Rb et un cation organique monovalent comprenant un groupe ammonium ou carboxamidamidium,
- B représente un cation organique monovalent de formule (II) suivante :

$$R^1\text{-}(CH_2)_z\text{-}R^2 \qquad (II)$$

dans laquelle :

- $R^2$ représente un groupe ammonium ou carboxamidamidium,
- z représente 1, 2 ou 3, et
- $R^1$ représente -H, -OH, -SH, -CN ou un halogène,
sous réserve que B soit différent de A,
- $X^1$ et $X^2$ représentent un halogénure, sous réserve que $X^1$ et $X^2$ soient différents l'un de l'autre,
- p est un nombre supérieur à 0 et inférieur ou égal à 0,30,
- b est un nombre supérieur ou égal à -0,30 et inférieur ou égal à 0,30, sous réserve que b soit supérieur à -3,48p et soit inférieur à (1 - 2,48p),
- y représente un nombre supérieur à 0 et inférieur ou égal à p,
- q représente un nombre supérieur ou égal à 0 et inférieur ou égal à (3-y),
- M représente un cation métallique divalent, et
- m représente un nombre supérieur ou égal à 0 et inférieur ou égal à (1-p).

2. Pérovskite selon la revendication 1, dans lequel $X^1$ représente un iodure et q représente 0.

3. Pérovskite selon la revendication 1 ou 2, dans lequel m représente 0.

**4.** Pérovskite selon l'une quelconque des revendications 1 à 3, dans lequel :

- le cation métallique divalent est choisi parmi Pb, Sn, Cu, Cd et Mn, et/ou
- l'halogénure est choisi parmi un iodure, un chlorure et un bromure, et/ou
- le cation organique monovalent A est choisi parmi Cs, Rb, le méthylammonium et le formamidinium, et/ou
- y est égal à p, et/ou
- p est un nombre supérieur à 0 et inférieur ou égal à 0,25, notamment de 0,01 à 0,25, en particulier de 0,05 à 0,23, et/ou
- b est un nombre supérieur ou égal à -0,20 et inférieur ou égal à 0,20, notamment un nombre supérieur ou égal à -0,10 et inférieur ou égal à 0,10, en particulier un nombre supérieur ou égal à -0,07 et inférieur ou égal à 0,07,
- m représente 0, et/ou
- q représente 0.

**5.** Pérovskite selon l'une quelconque des revendications 1 à 4, dans lequel le cation organique monovalent B de formule (II) est $HO\text{-}(CH_2)_2\text{-}NH_3^+$.

**6.** Pérovskite selon l'une quelconque des revendications précédentes, de formule (VII) suivante :

$$[(A)_{1-2,48p-b}(HO\text{-}(CH_2)_2\text{-}NH_3^+)_{3,48p+b}]_{(1+2p-y)/(1+p)}(Pb)_{1-p}(I)_{3-y} \qquad (VII)$$

dans laquelle A, p, b et y sont tels que définis à la revendication 1, de préférence A représente $CH_3NH_3^+$ et/ou y = p.

**7.** Pérovskite selon l'une quelconque des revendications précédentes, de formule (90), (92), (89), (93) ou (88) suivante :

$$(CH_3NH_3)_{0,8138}(HO\text{-}(CH_2)_2\text{-}NH_3)_{0,2848}[Pb_{0,9014}I_{2,9014}] \qquad (90),$$

$$(CH_3NH_3)_{0,6744}(HO\text{-}(CH_2)_2\text{-}NH_3)_{0,4586}[Pb_{0,8670}I_{2,8670}] \qquad (92),$$

$$(CH_3NH_3)_{0,5821}(HO\text{-}(CH_2)_2\text{-}NH_3)_{0,5763}[Pb_{0,8416}I_{2,8416}] \qquad (89),$$

$$(CH_3NH_3)_{0,5383}(HO\text{-}(CH_2)_2\text{-}NH_3)_{0,6405}[Pb_{0,8212}I_{2,8212}] \qquad (93),$$

ou

$$(CH_3NH_3)_{0,4730}(HO\text{-}(CH_2)_2\text{-}NH_3)_{0,7331}[Pb_{0,7940}I_{2,7940}] \qquad (88).$$

**8.** Pérovskite selon l'une quelconque des revendications 1 à 4, dans lequel le cation organique monovalent B de formule (II) est $HS\text{-}(CH_2)_2\text{-}NH_3^+$.

**9.** Pérovskite selon l'une quelconque des revendications 1 à 4 et 8, de formule (VIII) suivante :

$$[(A)_{1-2,48p-b}(HS\text{-}(CH_2)_2\text{-}NH_3^+)_{3,48p+b}]_{(1+2p-y)/(1+p)}(Pb)_{1-p}(I)_{3-y} \qquad (VIII)$$

dans laquelle A, p, b et y sont tels que définis ci-dessus, de préférence A représente FA et/ou y = p.

**10.** Pérovskite selon l'une quelconque des revendications 1 à 4, 8 et 9, de formule (T1) suivante :

$$(HC\text{-}(NH_2)_2)_{0,9177}(HS\text{-}(CH_2)_2\text{-}NH_3)_{0,1193}[Pb_{0,9630}I_{2,9630}] \qquad (T1).$$

**11.** Pérovskite selon l'une quelconque des revendications 1 à 10 sous forme de cristaux dont le système cristallin est de symétrie tétragonale.

**12.** Pérovskite selon l'une quelconque des revendications 1 à 10 sous forme de couche mince recouvrant au moins une partie de la surface d'un substrat.

**13.** Cellule photovoltaïque à pérovskites dont au moins l'une des couches contient la pérovskite selon l'une quelconque des revendications précédentes.

**Patentansprüche**

1. Ein organisch-anorganischer Hybrid-Perowskit der folgenden Formel (I):

$$[(A)_{1-2.48p-b}(B)_{3.48p+b}]_{(1+2p-y)/(1+p)}(Pb)_{1-p-m}(M)_m(X^1)_{3-y-q}(X^2)_q \qquad (I$$

) in denen:

- A ein Kation darstellt, das unter Cs, Rb und einem einwertigen organischen Kation mit einer Ammonium- oder Carboxamidamidiumgruppe ausgewählt ist,
- B ein einwertiges organisches Kation der folgenden Formel (II) darstellt:

$$R^1-(CH_2)_z-R^2 \qquad (II)$$

in der:

- $R^2$ eine Ammonium- oder Carboxamidamidiumgruppe darstellt,
- z 1, 2 oder 3 darstellt, und
- $R^1$ -H, -OH, -SH, -CN oder ein Halogen darstellt,
mit der Maßgabe, daß B eine andere Bedeutung als A hat,
- $X^1$ und $X^2$ ein Halogenid darstellen, mit der Maßgabe, daß $X^1$ und $X^2$ voneinander verschieden sind,
- p eine Zahl ist, die größer als 0 und kleiner oder gleich 0,30 ist,
- b eine Zahl ist, die größer oder gleich -0,30 und kleiner oder gleich 0,30 ist, mit der Maßgabe, dass b größer als -3,48p und kleiner als (1 - 2,48p) ist,
- y eine Zahl ist, die größer als 0 und kleiner oder gleich p ist,
- q eine Zahl größer als oder gleich 0 und kleiner als oder gleich (3-y) darstellt,
- M ein zweiwertiges Metallkation darstellt, und
- m eine Zahl größer als oder gleich 0 und kleiner als oder gleich (1-p) darstellt.

2. Perowskit nach Anspruch 1, in dem $X^1$ ein Iodid darstellt und q 0 ist.

3. Perowskit nach Anspruch 1 oder 2, worin m für 0 steht.

4. Perowskit nach einem der Ansprüche 1 bis 3, bei dem:

- das zweiwertige Metallkation ausgewählt ist aus Pb, Sn, Cu, Cd und Mn, und/oder
- das Halogenid ausgewählt ist aus einem Iodid, einem Chlorid und einem Bromid, und/oder
- das einwertige organische Kation A ausgewählt ist aus Cs, Rb, Methylammonium und Formamidinium, und/oder
- y gleich p ist, und/oder
- p eine Zahl größer als 0 und kleiner oder gleich 0,25 ist, insbesondere von 0,01 bis 0,25, insbesondere von 0,05 bis 0,23, und/oder
- b ist eine Zahl größer oder gleich -0,20 und kleiner oder gleich 0,20, insbesondere eine Zahl größer oder gleich -0,10 und kleiner oder gleich 0,10, insbesondere eine Zahl größer oder gleich -0,07 und kleiner oder gleich 0,07,
- m steht für 0, und/oder
- q für 0 steht.

5. Perowskit nach einem der Ansprüche 1 bis 4, bei dem das einwertige organische Kation B der Formel (II) HO-(CH$_2$)$_2$-NH$_3$+ ist.

6. Perowskit nach einem der vorhergehenden Ansprüche mit der folgenden Formel (VII):

$$[(A)_{1-2.48p-b}(HO-(CH_2)_2-NH_3+)_{3.48p+b}]_{(1+2p-y)/(1+p)}(Pb)_{1-p}(I)_{3-y} \qquad (VII)$$

in der A, p, b und y wie in Anspruch 1 definiert sind, vorzugsweise A CH3NH$_3$+ und/oder y = p bedeutet.

7. Perowskit nach einem der vorhergehenden Ansprüche, der nachstehenden Formel (90), (92), (89), (93) oder (88):

$$(CH3NH3)0.8138(HO-(CH2)2-NH3)0.2848[Pb0.901412.9014] \qquad (90),$$

$$(CH3NH3)0.6744(HO-(CH2)2-NH3)0.4586[Pb0.8670!2.8670] \qquad (92),$$

$$(CH3NH3)0.5821(HO-(CH2)2-NH3)0.5763[Pb0.841612.8416] \qquad (89),$$

$$(CH3NH3)0.5383(HO-(CH2)2-NH3)0.6405[Pb0.821212.8212] \qquad (93),$$

or

$$(CH3NH3)0.4730(HO-(CH2)2-NH3)0.7331[Pb0.7940!2.7940] \qquad (88).$$

8. Perowskit nach einem der Ansprüche 1 bis 4, bei dem das einwertige organische Kation B der Formel (II) $HS-(CH_2)_2-NH_3+$ ist.

9. Perowskit nach einem der Ansprüche 1 bis 4 und 8 mit der folgenden Formel (VIII):

$$[(A)_{1-2.48p-b}(HS-(CH_2)_2-NH_3+)_{3.48p+b}]_{(1,2p-y)/(1+p)}(Pb)_{1-p}(I)_{3-y} \qquad (VIII)$$

in der A, p, b und y wie oben definiert sind; vorzugsweise bedeutet A FA und/oder y = p.

10. Perowskit nach einem der Ansprüche 1 bis 4, 8 und 9 mit der folgenden Formel (T1):

$$(HC-(NH_2)_2)_{0.9177}(HS-(CH_2)_2-NH_3)_{0.1193}[Pb_{0.9630}I_{2.9630}] \qquad (T1).$$

11. Perowskit nach einem der Ansprüche 1 bis 10 in Form von Kristallen, deren Kristallsystem eine tetragonale Symmetrie aufweist.

12. Perowskit nach einem der Ansprüche 1 bis 10, in Form einer dünnen Schicht, die die Oberfläche eines Substrats zumindest teilweise bedeckt.

13. Perowskit-Solarzelle, bei der mindestens eine der Schichten den Perowskit nach einem der vorhergehenden Ansprüche enthält.

**Claims**

1. An organic-inorganic hybrid perovskite of formula (I) below:

$$[(A)_{1-2.48p-b}(B)_{3.48p+b}]_{(1+2p-y)/(1+p)}(Pb)_{1-p-m}(M)_m(X^1)_{3-y-q}(X^2)_q \qquad (I)$$

in which:

- A represents a cation chosen from Cs, Rb and a monovalent organic cation comprising an ammonium or carboxamidamidium group,
- B represents a monovalent organic cation of formula (II) below:

$$R^1-(CH_2)_z-R^2 \qquad (II)$$

in which:

- $R^2$ represents an ammonium or carboxamidamidium group,
- z represents 1, 2 or 3, and
- $R^1$ represents -H, -OH, -SH, -CN or a halogen,
  with the proviso that B is other than A,
- $X^1$ and $X^2$ represent a halide, with the proviso that $X^1$ and $X^2$ are different from each other,
- p is a number greater than 0 and less than or equal to 0.30,
- b is a number greater than or equal to -0.30 and less than or equal to 0.30, with the proviso that b is greater than -3.48p and is less than (1 - 2.48p),

- y represents a number greater than 0 and less than or equal to p,
- q represents a number greater than or equal to 0 and less than or equal to (3-y),
- M represents a divalent metal cation, and
- m represents a number greater than or equal to 0 and less than or equal to (1-p).

2. The perovskite as claimed in claim 1, in which $X^1$ represents an iodide and q represents 0.

3. The perovskite as claimed in claim 1 or 2, in which m represents 0.

4. The perovskite as claimed in any one of claims 1 to 3, in which:

- the divalent metal cation is chosen from Pb, Sn, Cu, Cd and Mn, and/or
- the halide is chosen from an iodide, a chloride and a bromide, and/or
- the monovalent organic cation A is chosen from Cs, Rb, methylammonium and formamidinium, and/or
- y is equal to p, and/or
- p is a number greater than 0 and less than or equal to 0.25, notably from 0.01 to 0.25, in particular from 0.05 to 0.23, and/or
- b is a number greater than or equal to -0.20 and less than or equal to 0.20, notably a number greater than or equal to -0.10 and less than or equal to 0.10, in particular a number greater than or equal to -0.07 and less than or equal to 0.07,

- m represents 0, and/or
- q represents 0.

5. The perovskite as claimed in any one of claims 1 to 4, in which the monovalent organic cation B of formula (II) is $HO\text{-}(CH_2)_2\text{-}NH_3^+$.

6. The perovskite as claimed in any one of the preceding claims, of formula (VII) below:

$$[(A)_{1-2.48p-b}(HO\text{-}(CH_2)_2\text{-}NH_3^+)_{3.48p+b}]_{(1+2p-y)/(1+p)}(Pb)_{1-p}(I)_{3-y} \qquad \text{(VII)}$$

in which A, p, b and y are as defined in claim 1, preferably A represents $CH_3NH_3^+$ and/or y = p.

7. The perovskite as claimed in any one of the preceding claims, of formula (90), (92), (89), (93) or (88) below:

$$(CH_3NH_3)_{0.8138}(HO\text{-}(CH_2)_2\text{-}NH_3)_{0.2848}[Pb_{0.9014}I_{2.9014}] \qquad \text{(90)},$$

$$(CH_3NH_3)_{0.6744}(HO\text{-}(CH_2)_2\text{-}NH_3)_{0.4586}[Pb_{0.8670}I_{2.8670}] \qquad \text{(92)},$$

$$(CH_3NH_3)_{0.5821}(HO\text{-}(CH_2)_2\text{-}NH_3)_{0.5763}[Pb_{0.8416}I_{2.8416}] \qquad \text{(89)},$$

$$(CH_3NH_3)_{0.5383}(HO\text{-}(CH_2)_2\text{-}NH_3)_{0.6405}[Pb_{0.8212}I_{2.8212}] \qquad \text{(93)},$$

or

$$(CH_3NH_3)_{0.4730}(HO\text{-}(CH_2)_2\text{-}NH_3)_{0.7331}[Pb_{0.7940}I_{2.7940}] \qquad \text{(88)}.$$

8. The perovskite as claimed in any one of claims 1 to 4, in which the monovalent organic cation B of formula (II) is $HS\text{-}(CH_2)_2\text{-}NH_3^+$.

9. The perovskite as claimed in any one of claims 1 to 4 and 8, of formula (VIII) below:

$$[(A)_{1-2.48p-b}(HS\text{-}(CH_2)_2\text{-}NH_3^+)_{3.48p+b}]_{(1+2p-y)/(1+p)}(Pb)_{1-p}(I)_{3-y} \qquad \text{(VIII)}$$

in which A, p, b and y are as defined above; preferably, A represents FA and/or y = p.

10. The perovskite as claimed in any one of claims 1 to 4, 8 and 9, of formula (T1) below:

$$(HC\text{-}(NH_2)_2)_{0.9177}(HS\text{-}(CH_2)_2\text{-}NH_3)_{0.1193}[Pb_{0.9630}I_{2.9630}] \qquad (T1).$$

11. The perovskite as claimed in any one of claims 1 to 10, in the form of crystals, the crystalline system of which is of tetragonal symmetry.

12. The perovskite as claimed in any one of claims 1 to 10, in the form of a thin layer at least partly covering the surface of a substrate.

13. A perovskite solar cell, at least one of the layers of which contains the perovskite as claimed in any one of the preceding claims.

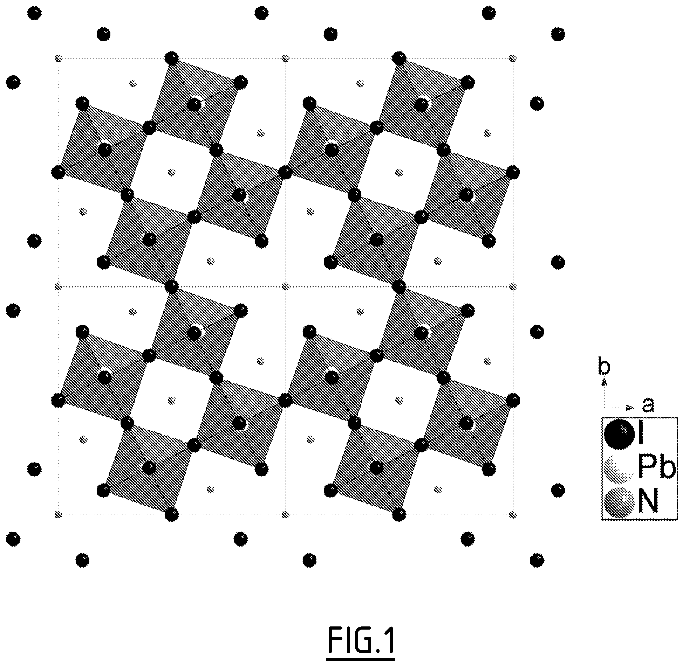

FIG.1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **ZHENG et al.** *Nature Energy,* 2017, vol. 2 (7), 17102-1
- **DUYEN et al.** *J. Am. Chem. Soc.,* 2015, vol. 137 (24), 7843-7850, https://doi.org/10.1021/jacs.5b03796
- **COVALIU et al.** *Optoelectronics and Advanced Materials,* 2011, vol. 5 (10), 1097-1102
- **J. LU.** *Advanced Energy Materials,* 2017, vol. 7, 1700444